# EUROPÄISCHE PATENTSCHRIFT

(11) **EP 3 586 577 B1**
(45) Veröffentlichungstag und Bekanntmachung des Hinweises auf die Patenterteilung: **09.12.2020**
(21) Anmeldenummer: 18701459.2
(22) Anmeldetag: 23.01.2018
(51) Int. Cl.: H05K 3/32, H05K 1/18, H05K 3/30, H05K 5/00, H05K 7/12, H05K 3/28

(54) **ELEKTRONIKMODUL SOWIE VERFAHREN ZUM HERSTELLEN EINES ELEKTRONIKMODULS**
ELECTRONIC MODULE AND METHOD FOR PRODUCING AN ELECTRONIC MODULE
MODULE ÉLECTRONIQUE ET PROCÉDÉ DE PRODUCTION D'UN MODULE ÉLECTRONIQUE

(30) Priorität: 23.02.2017 DE 102017202962
(43) Veröffentlichungstag der Anmeldung: 01.01.2020
(73) Patentinhaber: Robert Bosch GmbH, 70442 Stuttgart (DE)
(72) Erfinder: LISKOW, Uwe, 71679 Asperg (DE)
(86) Internationale Anmeldenummer: PCT/EP2018/051571
(87) Internationale Veröffentlichungsnummer: WO 2018/153595

(56) Entgegenhaltungen:
- DE-A1-102011 088 037
- DE-A1-102015 207 048
- DE-A1-102015 214 311
- JP-A- H02 268 491

## Beschreibung

### Gebiet der Erfindung

Die Erfindung betrifft ein Elektronikmodul sowie Verfahren zum Herstellen eines Elektronikmoduls.

### Stand der Technik

Elektronische Bauelemente, wie z.B. Sensoren, große elektrische Bauelemente und/oder Stecker, werden bei Elektronikmodulen auf den Leiterplattenelementen z.B. durch Schrauben und/oder Nietverbindungen befestigt oder in diese integriert. Aus den Sensoren, Bauelementen und/oder Steckern ragen Pins, die in Leiterplattenelementen und/oder Flexfolien (sogenannte Durchsteck-Lötkontakte) eingesteckt sind. Alternativ sind diese an weiterleitende Stanzgitter geschweißt oder gelötet. Mittels der Stanzgitter, Flexfolien und/oder Leiterplatten sind der Sensor und/oder der Stecker mit einem zentralen Getriebesteuergerät iTCU oder einem Getriebestecker verbunden.

Nachteilig an bisher bekannten Befestigungsarten von Sensoren, Bauelementen und/oder Steckern auf Leiterplattenelementen ist typischerweise, dass die Position des Sensors und/oder Steckers nur durch grundsätzliche Designänderungen geändert werden kann. Die Änderung der Position der elektronischen Bauelemente bzw. der Sensoren und/oder Stecker wird jedoch in der Regel dadurch erschwert, dass die Schrauben und/oder Nieten zum Befestigen der elektronischen Bauelemente Fläche und Volumen auf dem Leiterplattenelement benötigen.

Zudem werden elektronische Bauelemente mittels Reflow-Löten auf dem Leiterplattenelement befestigt. Daher müssen im Stand der Technik die Sensoren und/oder Stecker derart ausgebildet sein, dass sie die hohen Temperaturen beim Reflow-Löten ohne Schäden überstehen. Große elektrische Bauelemente wie Drosselspulen lassen sich aufgrund der hohen thermischen Masse (große Kupfermasse) nur bedingt reflow-löten.

DE 10 2015 214311 A1 offenbart ein Elektronikmodul, umfassend ein Leiterplattenelement und ein Sockelelement mit einem elektrisch leitenden Anschlusselement.

### Offenbarung der Erfindung

### Vorteile der Erfindung

Ausführungsformen der vorliegenden Erfindung können in vorteilhafter Weise ein Steuermodul ermöglichen, bei dem die Position eines elektronischen Bauelements bzw. eines Sensors und/oder eines Steckers auf dem Leiterplattenelement technisch einfach veränderbar ist.

Gemäß einem ersten Aspekt der Erfindung wird ein Elektronikmodul, insbesondere für eine Getriebesteuerung oder ein Elektrofahrzeug, vorgeschlagen, umfassend ein Leiterplattenelement, einen Sockel mit zumindest einem ersten elektrisch leitenden Kontaktelement, wobei der Sockel an dem Leiterplattenelement befestigt und mit dem Leiterplattenelement elektrisch verbunden ist, mindestens ein elektronisches Bauelement, wobei das elektronische Bauelement zumindest ein zweites elektrisch leitendes Kontaktelement umfasst, wobei das elektronische Bauelement über einen elektrischen Kontaktbereich zwischen dem ersten Kontaktelement und dem zweiten Kontaktelement elektrisch mit dem Sockel verbunden ist, dadurch gekennzeichnet, dass ein Abschnitt des ersten Kontaktelements auf einer ersten dem Leiterplattenelement abgewandten Seite des Sockels aus dem Sockel hervorsteht, wobei der aus dem Sockel hervorstehende Abschnitt des ersten Kontaktelements zumindest teilweise in einem Hohlraum des elektronischen Bauelements aufgenommen ist, wobei der aus dem Sockel hervorstehende Abschnitt des ersten Kontaktelements und/oder ein Abschnitt des zweiten Kontaktelements derart federnd ausgebildet ist, dass das elektronische Bauelement mittels Federkraft zwischen dem ersten Kontaktelement und dem zweiten Kontaktelement mechanisch an dem Sockel befestigt ist.

Ein Vorteil hiervon ist, dass das elektronische Bauelement technisch einfach an dem Leiterplattenelement befestigt werden kann. Darüber hinaus kann die Befestigungsposition des elektronischen Bauelements durch Änderung der Befestigungsposition des Sockels technisch einfach verändert werden. Darüber hinaus kann das elektronische Bauelement, insbesondere ein Sensor, ein großes elektrisches Bauelement und/oder Anschlussstecker, erst nach einem Reflow-Löten mittels des Sockels an dem Leiterplattenelement befestigt wird. Hierdurch wird das elektronische Bauelement bzw. der Sensor und/oder der Anschlussstecker den hohen Temperaturen beim Reflow-Löten nicht ausgesetzt. Daher kann das elektronische Bauelement aus einem kostengünstigen Material hergestellt sein. Dies senkt die Herstellungskosten.

Gemäß einem zweiten Aspekt der Erfindung wird ein Verfahren zum Herstellen eines Elektronikmoduls, insbesondere für eine Getriebesteuerung oder ein Elektrofahrzeug, vorgeschlagen, wobei das Verfahren folgendes umfasst: Bereitstellen eines Leiterplattenelements mit einer ersten Seite; Befestigen eines Sockels umfassend zumindest ein erstes Kontaktelement auf der ersten Seite des Leiterplattenelements und elektrisches Verbinden des Sockels mit dem Leiterplattenelement, wobei ein Abschnitt des ersten Kontaktelements auf einer ersten dem Leiterplattenelement abgewandten Seite des Sockels aus dem Sockel hervorsteht; und mechanisches Befestigen und elektrisches Verbinden eines elektronischen Bauelements mit zumindest einem zweiten Kontaktelement mit dem Sockel mittels einer Federkraft zwischen dem ersten Kontaktelement und dem zweiten Kontaktelement, wobei der Abschnitt des ersten Kontaktelements beim mechanischen Befestigen und elektrischen Verbinden des elektronischen Bauelements zumindest teilweise in einen Hohlraum des elektronischen Bauelements eingeführt wird.

Vorteilhaft hieran ist, dass das elektronische Bauelement technisch einfach an dem Leiterplattenelement befestigt wird. Darüber hinaus kann die Befestigungsposition des elektronischen Bauelements durch Änderung der Befestigungsposition des Sockels technisch einfach verändert werden. Darüber hinaus kann das elektronische Bauelement, insbesondere ein Sensor und/oder Anschlussstecker, erst nach einem Reflow-Löten mittels des Sockels an dem Leiterplattenelement befestigt wird. Hierdurch wird das elektronische Bauelement bzw. der Sensor und/oder der Anschlussstecker den hohen Temperaturen beim Reflow-Löten nicht ausgesetzt. Daher kann das elektronische Bauelement aus einem kostengünstigen Material hergestellt sein. Dies senkt die Herstellungskosten.

Ideen zu Ausführungsformen der vorliegenden Erfindung können unter anderem als auf den nachfolgend beschriebenen Gedanken und Erkenntnissen beruhend angesehen werden.

Gemäß einer Ausführungsform ist der Sockel durch Löten und/oder Einpresspins an der Leiterplatte befestigt. Hierdurch ist eine technisch einfache mechanische Befestigung des Sockels an dem Leiterplattenelement vorhanden. Darüber hinaus lässt sich die Position des Sockels in Bezug auf das Leiterplattenelement technisch einfach und schnell ändern.

Gemäß einer Ausführungsform ist der Hohlraum des elektronischen Bauelements mit einer Vergussmasse derart gefüllt, dass der elektrische Kontaktbereich zwischen dem ersten Kontaktelement und dem zweiten Kontaktelement von der Vergussmasse bedeckt ist. Ein Vorteil hiervon ist, dass der elektronische Kontaktbereich vor Metallspänen, Flüssigkeit und ähnlichem geschützt ist. Hierdurch werden Kurzschlüsse sicher verhindert.

Gemäß einer Ausführungsform ist der Hohlraum des elektronischen Bauelements mit einer Vergussmasse derart gefüllt, dass der von dem elektronischen Bauelement umschlossene Bereich im Wesentlichen vollständig mit Vergussmasse gefüllt ist. Ein Vorteil hiervon ist, dass die Stabilität des elektronischen Bauelements erhöht wird. Zudem wird der elektronische Kontaktbereich hierdurch ebenfalls vor Metallspänen, Flüssigkeit und ähnlichem geschützt, wodurch Kurzschlüsse verhindert werden.

Gemäß einer Ausführungsform ist eine erste Seite des Leiterplattenelements zumindest teilweise von einer Vergussmasse derart bedeckt, dass eine elektrische Verbindungsstelle, insbesondere umfassend ein Löt-Pad, zwischen dem Sockel und dem Leiterplattenelement von der Vergussmasse bedeckt ist. Ein Vorteil hiervon ist, dass die elektrische Verbindungsstelle sicher vor Metallspänen, Flüssigkeit und ähnlichem geschützt ist. Hierdurch werden Kurschlüsse verhindert.

Gemäß einer Ausführungsform weist das elektronische Bauelement mindestens einen Vorsprung zum Ausrichten des elektronischen Bauelements in Bezug auf das Leiterplattenelement auf, wobei der Vorsprung in eine Aussparung des Leiterplattenelements eingreift. Vorteilhaft hieran ist, dass das elektronische Bauelement technisch einfach in Bezug auf das Leiterplattenelement ausgerichtet wird.

Gemäß einer Ausführungsform ist das Leiterplattenelement auf einer Grundplatte angeordnet, und der Vorsprung durchgreift eine Aussparung des Leiterplattenelements und kontaktiert die Grundplatte. Ein Vorteil hiervon ist, dass die Einbauhöhe des elektronischen Bauelements, d.h. der (größte) Abstand des elektronischen Bauelements von der Grundplatte, unabhängig von der Dicke bzw. Höhe des Leiterplattenelements ist.

Gemäß einer Ausführungsform umfasst das Verfahren ferner folgende Schritte: Aufbringen einer Vergussmasse auf zumindest Teilbereiche der ersten Seite des Leiterplattenelements derart, dass eine elektrische Verbindungsstelle zwischen dem Sockel und dem Leiterplattenelement von der Vergussmasse bedeckt ist; und Aushärten der Vergussmasse. Ein Vorteil hiervon ist, dass die elektrische Verbindungsstelle sicher vor Metallspänen, Flüssigkeit und ähnlichem geschützt wird. Hierdurch werden Kurschlüsse verhindert.

Gemäß einer Ausführungsform umfasst das Verfahren ferner folgende Schritte: Einbringen einer Vergussmasse in den Hohlraum des elektronischen Bauelements derart, dass ein elektrischer Kontaktbereich zwischen dem ersten Kontaktelement und dem zweiten Kontaktelement von der Vergussmasse bedeckt ist; und Aushärten der Vergussmasse. Ein Vorteil hiervon ist, dass der elektronische Kontaktbereich vor Metallspänen, Flüssigkeit und ähnlichem geschützt wird. Hierdurch werden Kurzschlüsse sicher verhindert.

Es wird darauf hingewiesen, dass einige der möglichen Merkmale und Vorteile der Erfindung hierin mit Bezug auf unterschiedliche Ausführungsformen des Elektronikmoduls bzw. des Verfahrens zum Herstellen eines Elektronikmoduls beschrieben sind. Ein Fachmann erkennt, dass die Merkmale in geeigneter Weise kombiniert, angepasst oder ausgetauscht werden können, um zu weiteren Ausführungsformen der Erfindung zu gelangen.

### Kurze Beschreibung der Zeichnungen

Nachfolgend werden Ausführungsformen der Erfindung unter Bezugnahme auf die beigefügten Zeichnungen beschrieben, wobei weder die Zeichnungen noch die Beschreibung als die Erfindung einschränkend auszulegen sind.
- Fig. 1 zeigt: eine Querschnittsansicht einer ersten Ausführungsform des erfindungsgemäßen Elektronikmoduls;
- Fig. 2 zeigt: eine um 90° um eine vertikale Achse gedrehte Querschnittsansicht des Elektronikmoduls aus Fig. 1;
- Fig. 3 zeigt: eine Querschnittsansicht einer zweiten Ausführungsform des erfindungsgemäßen Elektronikmoduls;
- Fig. 4 zeigt: eine Querschnittsansicht einer dritten Ausführungsform des erfindungsgemäßen Elektronikmoduls; und
- Fig. 5 zeigt: eine Querschnittsansicht einer vierten Ausführungsform des erfindungsgemäßen Elektronikmoduls.

Die Figuren sind lediglich schematisch und nicht maßstabsgetreu. Gleiche Bezugszeichen bezeichnen in den Figuren gleiche oder gleichwirkende Merkmale.

### Ausführungsformen der Erfindung

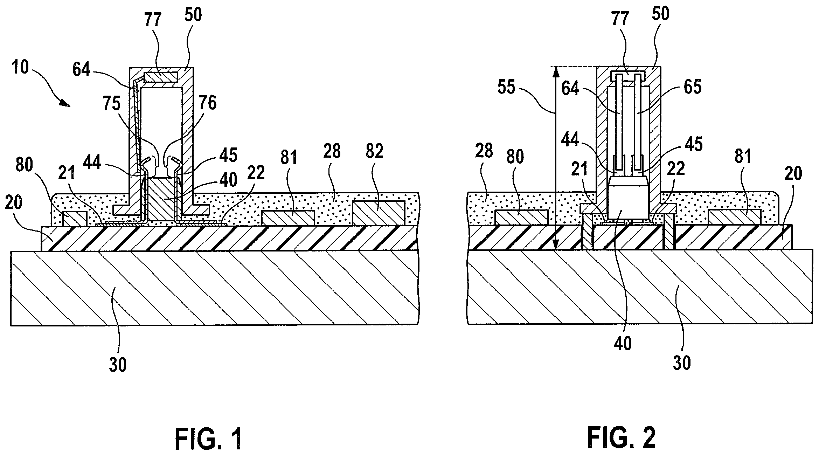

Fig. 1 zeigt eine Querschnittsansicht einer ersten Ausführungsform des erfindungsgemäßen Elektronikmoduls 10. Fig. 2 zeigt eine um 90° um eine vertikale Achse gedrehte Querschnittsansicht des Elektronikmoduls 10 aus Fig. 1.

Das Elektronikmodul 10 kann ein Elektronikmodul einer Getriebesteuerung sein oder zur Steuerung eines elektrischen Antriebs in einem Fahrzeug (z.B. in einem Elektrofahrzeug) ausgebildet sein. Die Getriebesteuerung kann die Getriebesteuerung eines Kraftfahrzeugs, z.B. eines PKW oder eines LKW, sein.

Das Elektronikmodul 10 umfasst mehrere elektronische Bauelemente. Neben typischen integrierten Schaltungen als elektronische Bauelemente (die unmittelbar bzw. direkt auf dem Leiterplattenelement 20 angeordnet sind) ist eine Sensorvorrichtung 50 auf dem Leiterplattenelement 20 angeordnet. Im Folgenden wird nur von einer Sensorvorrichtung 50 gesprochen. Anstelle oder zusätzlich zu einer Sensorvorrichtung 50 ist auch ein Anschlussstecker bzw. ein Anschluss vorstellbar.

Die Sensorvorrichtung 50 ist an einem Sockel 40 befestigt. Der Sockel 40 ist an dem Leiterplattenelement 20 befestigt. Die Sensorvorrichtung 50 ist über den Sockel 40 mit dem Leiterplattenelement 20 elektrisch verbunden.

Der Sockel 40 weist zwei erste Kontaktelemente 44, 45 auf. Die zwei ersten Kontaktelemente 44, 45 sind über Löt-Pads 21, 22 mit dem Leiterplattenelement 20 verbunden. Über diese Verbindung ist der Sockel 40 elektrisch und mechanisch mit dem Leiterplattenelement 20 verbunden bzw. verlötet. Vorstellbar ist auch, dass der Sockel 40 über Einpresspins mit dem Leiterplattenelement 20 elektrisch und mechanisch verbunden ist.

Die zwei ersten Kontaktelemente 44, 45 können wie in Fig. 1 dargestellt durchgehend bzw. einstückig ausgebildet sein. Alternativ ist auch vorstellbar, dass die zwei ersten Kontaktelemente 44, 45 zwei- oder mehrteilig ausgebildet sein. Zwischen den mehreren Teilen der eines ersten Kontaktelements 44, 45 muss eine elektrische Verbindung vorhanden sein, so dass die Sensorvorrichtung 50 elektrisch mit dem Leiterplattenelement 20 verbunden ist.

Auf der dem Leiterplattenelement 20 abgewandten Seite des Sockels 40 (dies ist in Fig. 1 bzw. Fig. 2 die obere Seite des Sockels 40) ragt ein Teil bzw. ein Abschnitt 75, 76 der ersten Kontaktelemente 44, 45 aus dem Sockel 40 heraus. Dieser Teil bzw. Abschnitt 75, 76 der ersten Kontaktelemente 44, 45 ist federnd ausgebildet. Dieser Teil bzw. Abschnitt 75, 76 der ersten Kontaktelemente 44, 45 ist in Fig. 1 bzw. Fig. 2 nach rechts und links reversibel bewegbar bzw. biegbar. Das erste Kontaktelement 44, 45 kann jeweils ein Draht und/oder ein Leitblech sein.

Die Sensorvorrichtung 50 weist einen Sensor 77 auf. Der Sensor 77 ist in dem Gehäuse der Sensorvorrichtung 50 eingeschlossen. Der Sensor 77 ist mit zwei zweiten Kontaktelementen 64, 65 elektrisch verbunden. Diese führen von dem Sensor 77 in Richtung des Leiterplattenelements 20. Die zweiten Kontaktelemente 64, 65 verlaufen teilweise innerhalb des Gehäuses der Sensorvorrichtung 50. Die Sensorvorrichtung 50 bzw. das Gehäuse der Sensorvorrichtung 50 umschließt einen Hohlraum. Ein Abschnitt bzw. Teil der zweiten Kontaktelemente 64, 65 steht jeweils in diesen Hohlraum hervor.

Dieser Abschnitt bzw. Teil der zweiten Kontaktelemente 64, 65 kann starr ausgebildet sein und über eine Federkraft mit den ersten Kontaktelementen 44, 45 jeweils verbunden sein. Vorstellbar ist auch, dass die zweiten Kontaktelemente 64, 65 federnd ausgebildet sein und der aus dem Sockel 40 nach oben herausstehende Teil der ersten Kontaktelemente 44, 45 ist starr ausgebildet. Auch hierbei kann mittels Federkraft eine mechanische und elektrische Verbindung zwischen den ersten Kontaktelementen 44, 45 und den zweiten Kontaktelementen 64, 65 gebildet werden.

Auch vorstellbar ist, dass sowohl die ersten Kontaktelemente 44, 45 als auch die zweiten Kontaktelemente 64, 65 federnd ausgebildet sind.

Durch die elektrische Verbindung zwischen den ersten Kontaktelementen 44, 45 und den zweiten Kontaktelemente 64, 65 wird eine elektrische Verbindung zwischen dem Sensor 77 und dem Leiterplattenelement 20 hergestellt.

Die Anzahl der ersten Kontaktelemente 44, 45 bzw. der zweiten Kontaktelemente 64, 65 kann auch eins, drei, vier oder mehr als vier betragen.

Die Seite des Leiterplattenelements 20, auf dem der Sockel 40 und die weiteren elektronischen Bauelemente 80-82 angeordnet sind, ist teilweise oder vollständig mit einer Vergussmasse 28 versehen. Die Vergussmasse 28 bedeckt die weiteren elektronischen Bauelementen 80-82 neben der Sensorvorrichtung 50, die Löt-Pads 21, 22, einen (unteren) Teil des Sockels 40 sowie einen (unteren) Teil der Sensorvorrichtung 50. Hierdurch wird die Sensorvorrichtung 50 zusätzlich an dem Leiterplattenelement 20 befestigt.

Das Vergussmaterial schützt die weiteren elektronischen Bauelemente 80-82 und die elektrische Verbindung zwischen dem Sockel 40 und dem Leiterplattenelement 20.

Das Leiterplattenelement 20 ist auf einer Grundplatte 30 angeordnet. Die Grundplatte 30 kann Teil des Gehäuses eines Getriebes, insbesondere für ein Kraftfahrzeug, sein. Die Grundplatte 30 kann auch zum Abführen von Wärme von dem Leiterplattenelement 20 ausgebildet sein.

Die Sensorvorrichtung 50 weist zwei Vorsprünge auf, die in Aussparungen 51 des Leiterplattenelements 20 angeordnet sein. Dies dient zur Ausrichtung der Sensorvorrichtung 50 in Bezug auf das Leiterplattenelement 20. Auch die Einbauhöhe 55 des elektronischen Bauelements bzw. der Sensorvorrichtung 50 kann mittels der Vorsprünge eingestellt werden. Die Einbauhöhe 55 ist der größte Abstand der Sensorvorrichtung 50 und der Grundplatte 30. Dies entspricht dem Abstand zwischen dem in Fig. 2 obersten Teil der Sensorvorrichtung 50 von der Grundplatte 30 bzw. von der der Sensorvorrichtung 50 zugewandten Seite der Grundplatte 30. Die der Sensorvorrichtung 50 zugewandte Seite der Grundplatte 30 ist in Fig. 1 und in Fig. 2 die obere Seite der Grundplatte 30.

Die Sensorvorrichtung 50 berührt das Leiterplattenelement 20 nicht direkt bzw. nicht unmittelbar. Die Sensorvorrichtung 50 berührt auch die Löt-Pads 21, 22 nicht direkt bzw. unmittelbar. Zwischen der Sensorvorrichtung 50 und dem Leiterplattenelement 20 bzw. den Löt-Pads 21, 22 ist ein Abstand vorhanden, der mit Vergussmaterial 28 gefüllt ist. Vorstellbar ist jedoch auch, dass die Sensorvorrichtung 50 das Leiterplattenelement 20 und/oder die Löt-Pads 21, 22 kontaktiert, so dass kein Abstand jeweils vorhanden ist.

In Fig. 2 durchgreifen die Vorsprünge das Leiterplattenelement 20 und ruhen auf der Grundplatte 30. Hierdurch kann die Einbauhöhe 55 der Sensorvorrichtung 50 unabhängig von der Dicke des Leiterplattenelements 20 eingestellt werden. Die Dicke des Leiterplattenelements 20 erstreckt sich in Fig. 1 bzw. Fig. 2 von unten nach oben. Fig. 2 zeigt eine gegenüber Fig. 1 um 90° um eine vertikal verlaufende Achse gedrehte Ansicht der ersten Kontaktelemente 44, 45 und der zweiten Kontaktelemente 64, 65. In Fig. 2 ist deutlich zu sehen, wie die federnd ausgebildeten Abschnitt 75, 76 der ersten Kontaktelemente 44, 45 jeweils gegen die zweiten Kontaktelemente 64, 65 drücken. Die federnd ausgebildeten Abschnitte 75, 76 drücken in Fig. 2 in eine Richtung, die aus der Zeichenebene der Fig. 2 heraus verläuft.

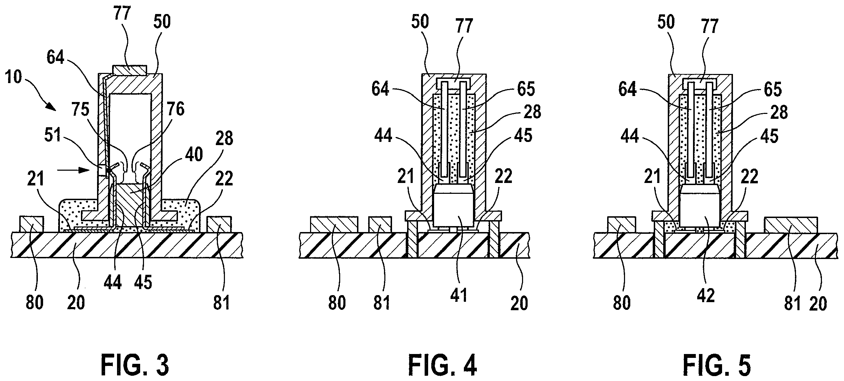

Fig. 3 zeigt eine Querschnittsansicht einer zweiten Ausführungsform des erfindungsgemäßen Elektronikmoduls 10. Die in Fig. 3 gezeigte Ausführungsform unterscheidet sich im Wesentlichen von der in Fig. 1 bzw. Fig. 2 gezeigten Ausführungsform dadurch, dass die ersten Kontaktelemente 44, 45 über eine Aussparung 51 in dem Gehäuse der Sensorvorrichtung 50 zusätzlich mit den zweiten Kontaktelementen 64, 65 im elektrischen Kontaktbereich mittels Laser verschweißt sind. Dies erhöht die mechanische Festigkeit. Zudem ist ein Unterschied, dass die weiteren elektronischen Bauelemente 80-82 nicht von dem Vergussmaterial bedeckt sind.

Fig. 4 zeigt eine Querschnittsansicht einer dritten Ausführungsform des erfindungsgemäßen Elektronikmoduls 10. Hier ist die Vergussmasse 28 in den Hohlraum oberhalb des Sockels 40 eingebracht. Die Vergussmasse 28 bedeckt keinen Teil des Leiterplattenelements 20. Der elektrische Kontaktbereich bzw. die elektrischen Kontaktbereiche zwischen den ersten Kontaktelementen 44, 45 und den zweiten Kontaktelement 64, 65 ist bzw. sind von dem Vergussmaterial bedeckt.

Fig. 5 zeigt eine Querschnittsansicht einer vierten Ausführungsform des erfindungsgemäßen Elektronikmoduls 10. Hier füllt das Vergussmaterial den kompletten von der Sensorvorrichtung 50 umschlossenen Hohlraum aus. Der elektrische Kontaktbereich bzw. die elektrischen Kontaktbereiche zwischen den ersten Kontaktelementen 44, 45 und den zweiten Kontaktelement 64, 65 ist bzw. sind von dem Vergussmaterial bedeckt.

Abschließend ist darauf hinzuweisen, dass Begriffe wie "aufweisend", "umfassend", etc. keine anderen Elemente oder Schritte ausschließen und Begriffe wie "eine" oder "ein" keine Vielzahl ausschließen. Bezugszeichen in den Ansprüchen sind nicht als Einschränkung anzusehen.

## Patentansprüche

1. Elektronikmodul (10), insbesondere für eine Getriebesteuerung oder ein Elektrofahrzeug, umfassend
ein Leiterplattenelement (20),
einen Sockel (40) mit zumindest einem ersten elektrisch leitenden Kontaktelement (44, 45), wobei der Sockel (40) an dem Leiterplattenelement (20) befestigt und mit dem Leiterplattenelement (20) elektrisch verbunden ist, mindestens ein elektronisches Bauelement (50), wobei das elektronische Bauelement (50) zumindest ein zweites elektrisch leitendes Kontaktelement (64, 65) umfasst,
wobei das elektronische Bauelement (50) über einen elektrischen Kontaktbereich zwischen dem ersten Kontaktelement (44, 45) und dem zweiten Kontaktelement (64, 65) elektrisch mit dem Sockel (40) verbunden ist,
**dadurch gekennzeichnet, dass**
ein Abschnitt (75, 76) des ersten Kontaktelements (44, 45) auf einer ersten dem Leiterplattenelement (20) abgewandten Seite des Sockels (40) aus dem Sockel (40) hervorsteht, wobei der aus dem Sockel (40) hervorstehende Abschnitt (75, 76) des ersten Kontaktelements (44, 45) zumindest teilweise in einem Hohlraum des elektronischen Bauelements (50) aufgenommen ist, wobei der aus dem Sockel (40) hervorstehende Abschnitt (75, 76) des ersten Kontaktelements (44, 45) und/oder ein Abschnitt des zweiten Kontaktelements (64, 65) derart federnd ausgebildet ist, dass das elektronische Bauelement (50) mittels Federkraft zwischen dem ersten Kontaktelement (44, 45) und dem zweiten Kontaktelement (64, 65) mechanisch an dem Sockel (40) befestigt ist.

2. Elektronikmodul (10) nach Anspruch 1, wobei
der Sockel (40) durch Löten und/oder Einpresspins an der Leiterplatte befestigt ist.

3. Elektronikmodul (10) nach Anspruch 1 oder 2, wobei
der Hohlraum des elektronischen Bauelements (50) mit einer Vergussmasse (28) derart gefüllt ist, dass der elektrische Kontaktbereich zwischen dem ersten Kontaktelement (44, 45) und dem zweiten Kontaktelement (64, 65) von der Vergussmasse (28) bedeckt ist.

4. Elektronikmodul (10) nach einem der vorhergehenden Ansprüche, wobei
der Hohlraum des elektronischen Bauelements (50) mit einer Vergussmasse (28) derart gefüllt ist, dass der von dem elektronischen Bauelement (50) umschlossene Bereich im Wesentlichen vollständig mit Vergussmasse (28) gefüllt ist.

5. Elektronikmodul (10) nach einem der vorhergehenden Ansprüche, wobei
eine erste Seite des Leiterplattenelements (20) zumindest teilweise von einer Vergussmasse (28) derart bedeckt ist, dass eine elektrische Verbindungsstelle, insbesondere umfassend ein Löt-Pad (21, 22), zwischen dem Sockel (40) und dem Leiterplattenelement (20) von der Vergussmasse (28) bedeckt ist.

6. Elektronikmodul (10) nach einem der vorhergehenden Ansprüche, wobei
das elektronische Bauelement (50) mindestens einen Vorsprung zum Ausrichten des elektronischen Bauelements (50) in Bezug auf das Leiterplattenelement (20) aufweist, wobei der Vorsprung in eine Aussparung (51) des Leiterplattenelements (20) eingreift.

7. Elektronikmodul (10) nach Anspruch 6, wobei
das Leiterplattenelement (20) auf einer Grundplatte (30) angeordnet ist, und wobei der Vorsprung eine Aussparung (51) des Leiterplattenelements (20) durchgreift und die Grundplatte (30) kontaktiert.

8. Verfahren zum Herstellen eines Elektronikmoduls (10), insbesondere für eine Getriebesteuerung oder ein Elektrofahrzeug, wobei das Verfahren folgendes umfasst:
Bereitstellen eines Leiterplattenelements (20) mit einer ersten Seite;
Befestigen eines Sockels (40) umfassend zumindest ein erstes Kontaktelement (44, 45) auf der ersten Seite des Leiterplattenelements (20) und elektrisches Verbinden des Sockels (40) mit dem Leiterplattenelement (20), wobei ein Abschnitt (75, 76) des ersten Kontaktelements (44, 45) auf einer ersten dem Leiterplattenelement (20) abgewandten Seite des Sockels (40) aus dem Sockel (40) hervorsteht; und
mechanisches Befestigen und elektrisches Verbinden eines elektronischen Bauelements (50) mit zumindest einem zweiten Kontaktelement (64, 65) mit dem Sockel (40) mittels einer Federkraft zwischen dem ersten Kontaktelement (44, 45) und dem zweiten Kontaktelement (64, 65),
wobei der Abschnitt (75, 76) des ersten Kontaktelements (44, 45) beim mechanischen Befestigen und elektrischen Verbinden des elektronischen Bauelements (50) zumindest teilweise in einen Hohlraum des elektronischen Bauelements (50) eingeführt wird.

9. Verfahren nach Anspruch 8, ferner folgende Schritte umfassend:
Aufbringen einer Vergussmasse (28) auf zumindest Teilbereiche der ersten Seite des Leiterplattenelements (20) derart, dass eine elektrische Verbindungsstelle zwischen dem Sockel (40) und dem Leiterplattenelement (20) von der Vergussmasse (28) bedeckt ist; und
Aushärten der Vergussmasse (28).

10. Verfahren nach Anspruch 8 oder 9, ferner folgende Schritte umfassend:
Einbringen einer Vergussmasse (28) in den Hohlraum des elektronischen Bauelements (50) derart, dass ein elektrischer Kontaktbereich zwischen dem ersten Kontaktelement (44, 45) und dem zweiten Kontaktelement (64, 65) von der Vergussmasse (28) bedeckt ist; und
Aushärten der Vergussmasse (28).

## Claims

1. Electronic module (10), in particular for a transmission controller or an electric vehicle, comprising a printed circuit board element (20),
a base (40) having at least one first electrically conductive contact element (44, 45), wherein the base (40) is fastened on the printed circuit board element (20) and is electrically connected to the printed circuit board element (20),
at least one electronic component (50), wherein the electronic component (50) comprises at least one second electrically conductive contact element (64, 65),
wherein the electronic component (50) is electrically connected to the base (40) via an electrical contact region between the first contact element (44, 45) and the second contact element (64, 65),
**characterized in that**
a section (75, 76) of the first contact element (44, 45) protrudes out of the base (40) on a first side of the base (40) facing away from the printed circuit board element (20), wherein the section (75, 76) of the first contact element (44, 45) protruding out of the base (40) is at least partially accommodated in a cavity of the electronic component (50), wherein the section (75, 76) of the first contact element (44, 45) protruding out of the base (40) and/or a section of the second contact element (64, 65) is formed resilient in such a way that the electronic component (50) is mechanically fastened on the base (40) by means of spring force between the first contact element (44, 45) and the second contact element (64, 65).

2. Electronic module (10) according to Claim 1, wherein the base (40) is fastened on the printed circuit board by soldering and/or press-in pins.

3. Electronic module (10) according to Claim 1 or 2, wherein the cavity of the electronic component (50) is filled using a potting compound (28) in such a way that the electrical contact region between the first contact element (44, 45) and the second contact element (64, 65) is covered by the potting compound (28).

4. Electronic module (10) according to any one of the preceding claims, wherein
the cavity of the electronic component (50) is filled using a potting compound (28) in such a way that the region enclosed by the electronic component (50) is substantially completely filled using potting compound (28).

5. Electronic module (10) according to any one of the preceding claims, wherein
a first side of the printed circuit board element (20) is at least partially covered by a potting compound (28) in such a way that an electrical connection point, in particular comprising a solder pad (21, 22), between the base (40) and the printed circuit board element (20) is covered by the potting compound (28).

6. Electronic module (10) according to any one of the preceding claims, wherein
the electronic component (50) has at least one projection for aligning the electronic component (50) in relation to the printed circuit board element (20), wherein the projection engages in a recess (51) of the printed circuit board element (20).

7. Electronic module (10) according to Claim 6, wherein the printed circuit board element (20) is arranged on a base plate (30), and wherein the projection engages through a recess (51) of the printed circuit board element (20) and contacts the base plate (30).

8. Method for producing an electronic module (10), in particular for a transmission controller or an electric vehicle, wherein the method comprises the following:
providing a printed circuit board element (20) having a first side;
fastening a base (40) comprising at least one first contact element (44, 45) on the first side of the printed circuit board element (20) and electrically connecting the base (40) to the printed circuit board element (20), wherein a section (75, 76) of the first contact element (44, 45) protrudes out of the base (40) on a first side of the base (40) facing away from the printed circuit board element (20); and
mechanically fastening and electrically connecting an electronic component (50) having at least one second contact element (64, 65) to the base (40) by means of a spring force between the first contact element (44, 45) and the second contact element (64, 65),
wherein the section (75, 76) of the first contact element (44, 45) is at least partially inserted into a cavity of the electronic component (50) during the mechanical fastening and electrical connection of the electronic component (50).

9. Method according to Claim 8, furthermore comprising the following steps:
applying a potting compound (28) to at least partial regions of the first side of the printed circuit board element (20) in such a way that an electrical connection point between the base (40) and the printed circuit board element (20) is covered by the potting compound (28); and
curing the potting compound (28).

10. Method according to Claim 8 or 9, furthermore comprising the following steps:
introducing a potting compound (28) into the cavity of the electronic component (50) in such a way that an electrical contact region between the first contact element (44, 45) and the second contact element (64, 65) is covered by the potting compound (28); and
curing the potting compound (28).

## Revendications

1. Module électronique (10), en particulier pour une commande de transmission ou un véhicule électrique, comprenant
un élément de carte de circuits imprimés (20),
un socle (40) doté d'au moins un premier élément de contact électriquement conducteur (44, 45), le socle (40) étant fixé à l'élément de carte de circuits imprimés (20) et relié électriquement à l'élément de carte de circuits imprimés (20),
au moins un composant électronique (50), le composant électronique (50) comprenant au moins un deuxième élément de contact électriquement conducteur (64, 65),
dans lequel le composant électronique (50) est relié électriquement au socle (40) par une zone de contact électrique entre le premier élément de contact (44, 45) et le deuxième élément de contact (64, 65),
**caractérisé en ce que** qu'une partie (75, 76) du premier élément de contact (44, 45) dépasse du socle (40) sur une première face du socle (40) détournée de l'élément de carte de circuits imprimés (20), la partie (75, 76) dépassant du socle (40) du premier élément de contact (44, 45) étant reçue au moins en partie dans une cavité du composant électronique (50),
dans lequel la partie (75, 76) dépassant du socle (40) du premier élément de contact (44, 45) et/ou une partie du deuxième élément de contact (64, 65) est/sont réalisée(s) de manière élastique de telle sorte que le composant électronique (50) est fixé mécaniquement au socle (40) par une force de ressort entre le premier élément de contact (44, 45) et le deuxième élément de contact (64, 65).

2. Module électronique (10) selon la revendication 1, dans lequel le socle (40) est fixé à la carte de circuits imprimés par soudage et/ou des broches d'insertion.

3. Module électronique (10) selon la revendication 1 ou 2, dans lequel la cavité du composant électronique (50) est remplie d'une masse de scellement (28) de telle sorte que la zone de contact électrique entre le premier élément de contact (44, 45) et le deuxième élément de contact (64, 65) est recouverte par la masse de scellement (28).

4. Module électronique (10) selon l'une quelconque des revendications précédentes, dans lequel la cavité du composant électronique (50) est remplie avec une masse de scellement (28) de telle sorte que la zone entourée par le composant électronique (50) est remplie avec la masse de scellement (28) de manière substantiellement complète.

5. Module électronique (10) selon l'une quelconque des revendications précédentes, dans lequel une première face de l'élément de carte de circuits imprimés (20) est recouverte au moins en partie par une masse de scellement (28) de telle sorte qu'une jonction électrique, comprenant en particulier une pastille de soudage (21, 22), entre le socle (40) et l'élément de carte de circuits imprimés (20) est recouverte par la masse de scellement (28).

6. Module électronique (10) selon l'une quelconque des revendications précédentes, dans lequel le composant électronique (50) présente au moins une saillie pour aligner le composant électronique (50) par rapport à l'élément de carte de circuits imprimés (20), la saillie pénétrant dans un évidement (51) de l'élément de carte de circuits imprimés (20).

7. Module électronique (10) selon la revendication 6, dans lequel l'élément de carte de circuits imprimés (20) est disposé sur une plaque de base (30), et dans lequel la saillie traverse un évidement (51) de l'élément de carte de circuits imprimés (20) et entre en contact avec la plaque de base (30).

8. Procédé de fabrication d'un module électronique (10), en particulier pour une commande de transmission ou un véhicule électrique, le procédé comprenant les étapes consistant à :
fournir un élément de carte de circuits imprimés (20) ayant une première face ;
fixer un socle (40) qui comprend au moins un premier élément de contact (44, 45) sur la première face de l'élément de carte de circuits imprimés (20) et relier électriquement le socle (40) à l'élément de carte de circuits imprimés (20), une partie (75, 76) du premier élément de contact (44, 45) dépassant du socle (40) sur une face du socle (40) détournée de l'élément de carte de circuits imprimés (20) ; et
fixer mécaniquement et relier électriquement au socle (40) un composant électronique (50) doté d'au moins un deuxième élément de contact (64, 65), au moyen d'une force de ressort entre le premier élément de contact (44, 45) et le deuxième élément de contact (64, 65), dans lequel la partie (75, 76) du premier élément de contact (44, 45) est introduite au moins en partie dans une cavité du composant électronique (50) lors de la fixation mécanique et de la liaison électrique du composant électronique (50).

9. Procédé selon la revendication 8, comprenant en outre les étapes suivantes consistant à :
appliquer une masse de scellement (28) à au moins des zones partielles de la première face de l'élément de carte de circuits imprimés (20) de telle sorte qu'une jonction électrique entre le socle (40) et l'élément de carte de circuits imprimés (20) est recouverte par la masse de scellement (28) ; et
laisser durcir la masse de scellement (28).

10. Procédé selon la revendication 8 ou 9, comprenant en outre les étapes suivantes consistant à :
introduire une masse de scellement (28) dans la cavité du composant électronique (50) de telle sorte qu'une zone de contact électrique entre le premier élément de contact (44, 45) et le deuxième élément de contact (64, 65) est recouverte par la masse de scellement (28) ; et
laisser durcir la masse de scellement (28).
